# EUROPÄISCHE PATENTSCHRIFT

(11) **EP 1 266 402 B1**
(45) Veröffentlichungstag und Bekanntmachung des Hinweises auf die Patenterteilung: **22.01.2014**
(21) Anmeldenummer: 01925291.5
(22) Anmeldetag: 23.02.2001
(51) Int. Cl.: H01L 21/60

(54) **HALBLEITERBAUELEMENT UND VERFAHREN ZU DESSEN HERSTELLUNG**
SEMICONDUCTOR ELEMENT AND METHOD FOR PRODUCING THE SAME
COMPOSANT A SEMI-CONDUCTEUR ET PROCEDE DE FABRICATION DUDIT ELEMENT

(30) Priorität: 23.03.2000 DE 10014300
(43) Veröffentlichungstag der Anmeldung: 18.12.2002
(73) Patentinhaber: Qimonda AG i.IN., 81739 München (DE)
(72) Erfinder: HEDLER, Harry, 93049 Regensburg (DE); MEYER, Thorsten, 93047 Regensburg (DE)
(74) Vertreter: Epping - Hermann - Fischer
(86) Internationale Anmeldenummer: PCT/DE2001/000702
(87) Internationale Veröffentlichungsnummer: WO 2001/071799

(56) Entgegenhaltungen:
- EP-A- 0 609 918
- EP-A- 0 620 701
- US-A- 5 508 228
- US-A- 5 714 252
- US-A- 5 874 782
- US-A- 5 959 362

## Beschreibung

Die Erfindung betrifft ein Verfahren zur Herstellung eines Halbleiterbauelements mit einem Halbleiterchip, der auf einer ersten Hauptseite zumindest einen Kontaktpad und eine den zumindest einen Kontaktpad aussparende Schutzschicht aufweist, wobei das Halbleiterbauelement mittels Flip-Chip-Kontaktierung mit einem Substrat verbindbar ist.

Es existiert ein grundsätzliches Bedürfnis, Halbleiterbauelemente möglichst kostengünstig und platzsparend mit einem Substrat zu verbinden. In der Vergangenheit haben sich unterschiedliche Gehäusebauformen ausgebildet, bei denen ein Halbleiterchip beispielsweise auf einen Leadframe aufgebracht sein kann. Die Anschlussfinger des Leadframes schauen aus dem Gehäuse des Halbleiterbauelementes heraus und sind mit einem Substrat verbindbar. Beispiele für derartige Halbleiterbauelemente sind die sogenannten Small Outline Packages (SOP) oder Thin Small Outline Packages (TSOP). Bei diesen Bauformen entsteht ein verhältnismäßig hoher Abstand zwischen dem Halbleiterbauelement und dem Substrat. Alternativ hierzu existieren Halbleiterbauelemente mit sogenannten Ball Grid Arrays. Bei diesen werden Lötkugeln (Balls) auf Kontaktstellen auf der Unterseite des Halbleiterbauelementes aufgebracht, wobei die Lötkugeln eine elektrische Verbindung zu Kontakten des Substrates herstellen. Ball Grid Arrays weisen den Vorteil auf, daß über die Gehäuseberandung keine Kontaktelemente hinausstehen. Der Abstand zwischen dem Halbleiterbauelement und dem Substrat ist bei Ball Grid Arrays durch den Durchmesser der Lötkugeln bestimmt. Eine Verkleinerung des Abstandes ist mit Rücksicht auf eine zuverlässige elektrische Verbindbarkeit unter einen bestimmten Mindestdurchmesser der Lötkugeln (zirka 100 µm) nicht möglich.

Eine Verkleinerung des Abstandes zwischen dem Halbleiterbauelement und dem Substrat ist durch neue Chip-On-Board (COB) - Lösungen möglich, bei denen ein anisotrop leitfähiger Kleber zur Verbindung des Halbleiterchips mit dem Substrat verwendet wird. Hierbei wird ein Kleber verwendet, der mit winzigen Metallpartikeln mit einem Durchmesser von zirka 5 bis 10 *µ*m versehen ist. Die Metallpartikel stellen dabei einen elektrischen Kontakt zwischen den Kontaktpads des Halbleiterchips und den Kontaktstellen auf dem Substrat her. Hierbei muß jedoch sichergestellt sein, daß die Kontaktpads auf dem Halbleiterchip eine Überhöhung aufweisen. Hierzu wird als Verfahrensschritt bei der Herstellung eine spezielle chemische Metallisierung der Kontaktpads mittels Nickel und Gold durchgeführt.

Mittels dieser Verbindungstechnologie zwischen einem Halbleiterchip und dem Substrat läßt sich eine äußerst geringe Bauhöhe erzielen, die lediglich durch die Dicke der Kleberschicht, das heißt durch den Durchmesser der Metallpartikel in dem Kleber bestimmt ist. Jedoch spricht auch eine Reihe von Nachteilen gegen diese Verbindungstechnologie. Zur Verbindung des Halbleiterchips mit dem Substrat ist eine äußerst hohe Positioniergenauigkeit des Halbleiterchips auf dem Substrat notwendig. Der Halbleiterchip darf beim Aufbringen auf das Substrat höchstens um 5 *µ*m von seiner Sollposition entfernt sein, da die Kontaktpads des Halbleiterchips in der Regel einen Durchmesser von weniger als 60 *µ*m aufweisen. Bei einer größeren seitlichen Verschiebung wie oben angegeben könnte ein schlechter elektrischer Kontakt zwischen dem Kontaktpad und der Kontaktstelle des Substrats die Folge sein. Weiterhin muß der Abstand zwischen den Kontaktstellen auf dem Substrat dieselbe Größenordnung aufweisen wie die Kontaktpads des Halbleiterchips. Der Abstand zwischen zwei Kontaktstellen dürfte dann maximal 100 *µ*m betragen. Hierdurch können konventionelle preiswerte Verfahren zur Herstellung des Substrates nicht mehr verwendet werden, da der standardmäßige Abstand zwischen zwei Kontaktstellen des Substrats bei 500 bis 800 *µ*m liegt. Stattdessen müssten teure Dünnfilm-Substrate verwendet werden. Da die Größe der Metallpartikel in dem anisotropleitfähigen Kleber sehr geringe Durchmesser aufweisen, muß zudem für eine äußerst exakte Ebenheit der Verbindungsfläche zwischen dem Halbleiterchip und dem Substrat gesorgt werden. Nicht zuletzt ist die Herstellung des Klebers mit gleich großen Metallpartikeln, die zumeist aus Silber bestehen, sehr aufwendig und kostenintensiv.

Aus der US 5,874,782 ist eine Anordnung mit einem Chip bekannt, der Kontaktpads und eine die Kontaktpads aussparende Schutzschicht aufweist. Erhebungen auf der Unterseite des Chips sind über Leiterzüge mit den Kontaktpads verbunden. Der Chip ist mittels Flip-Chip-Kontaktierung mit einem Substrat verbunden.

Die Aufgabe der vorliegenden Erfindung besteht darin, ein Verfahren zur Herstellung einer Halbleiterbauelementanordnung bereitzustellen, bei dem ein Halbleiterchip auf einfache und kostengünstige Weise mit einem Substrat verbunden wird, wobei der Halbleiterchip mit möglichst geringem Abstand zu dem Substrat angeordnet werden kann.

Gemäß der Erfindung umfasst ein Verfahren zur Herstellung einer Halbleiterbauelementanordnung mit einem Halbleiterchip, der auf einer ersten Hauptseite zumindest zwei Kontaktpads und eine die zumindest zwei Kontaktpads aussparende Schutzschicht aufweist und der Erhebungen auf der ersten Hauptseite, die in der von der ersten Hauptseite abgewandten Richtung verjüngt sind, aufweist, folgende Schritte:
a) Strukturierung der Halbleiterchips auf der ersten Hauptseite auf Waferebene,
b) Aufbringen der Erhebungen auf der ersten Hauptseite auf Waferebene,
c) Aufbringen von Leiterzügen auf der ersten Hauptseite, wobei die Kontaktpads und die Erhebungen miteinander verbunden werden und wobei Schritt c) nach Schritt b) ausgeführt wird,
d) Vereinzeln der Halbleiterchips und
e) Verbinden eines der Halbleiterchips und eines Substrates mit Kontaktstellen mittels eines Klebers, der zur Entwicklung seiner Adhäsivkraft schrumpft, wobei, wenn der Kleber noch nicht ausgehärtet ist, keine oder nur ungenügende elektrische Verbindung zwischen den Erhebungen und den Kontaktstellen besteht und wobei beim Schrumpfen des Klebers der Halbleiterchip an das Substrat herangezogen wird, so dass sich die Erhebungen in die Kontaktstellen hineinbohren, um einen sicheren elektrischen Kontakt zu ermöglichen.

Vorteilhafte Ausgestaltungen der Erfindungen ergeben sich aus den Unteransprüchen.

Gemäß Ausführungen sind die Abstände zwischen zwei Erhebungen an die Abstände der Kontaktstellen des Substrates angepaßt. Der Halbleiterchip ist mittels Flip-Chip-Kontaktierung mit dem Kontaktstellen aufweisenden Substrat verbunden. Die Erhebungen sind in die Kontaktstellen hinein gebohrt. Ein Kleber ist zur Verbindung des Halbleiterchips und des Substrates vorgesehen, der zur Entwicklung seiner Adhäsivkraft schrumpft.

Die Erfindung nutzt folglich das Prinzip der Umverdrahtung, damit Standardsubstrate mit den gewohnten Abständen zwischen zwei Kontaktstellen verwendet werden können. Die Erhebungen sind dabei derart auf der ersten Hauptseite des Halbleiterchips angeordnet, daß diese mit entsprechenden Kontaktstellen des Substrates zusammentreffen. Dies gilt selbstverständlich nur für derartige Erhebungen, auf denen Leiterzüge aufgebracht sind, die mit Kontaktpads des Halbleiterchips verbunden sind. Die Verbindung zwischen dem Halbleiterbauelement und dem Substrat kann mit preiswerten, nicht leitenden Standard-Klebern erfolgen.

Vorteilhafterweise verjüngt sich die Erhebung in der von der Hauptseite abgewandten Richtung. In Verbindung mit dem Kleber zur Verbindung des Halbleiterchips und des Substrates, der zur Entwicklung seiner Adhäsivkraft schrumpft, wird der Halbleiterchip an das Substrat "herangezogen". Durch die "Spitzen" der Erhebungen verbinden sich diese mit den entsprechenden Kontaktstellen des Substrates. Die Erhebungen bohren sich quasi in das Substrat hinein.

Vorteilhafterweise besteht die Erhebung aus einem druckbaren Material. Hiermit ist es möglich, die Erhebungen bereits auf Waferebene in einem einzigen Schritt auf eine Vielzahl an Halbleiterchips aufzubringen. Die Leiterzüge verlaufen entweder über eine derartige Erhebung hinweg oder aber enden auf dem Scheitelbereich der Erhebung, wobei sie von der ersten Hauptseite her entlang des Randbereiches auf dem Scheitelbereich der Erhebung endend hinauf verlaufen.

Als Material für die Erhebung kann beispielsweise ein Polymer oder ein Polyimid vorgesehen sein. Es ist auch jedes andere Material denkbar, daß sich mittels eines Druckprozesses verarbeiten läßt. Selbstverständlich wäre auch denkbar, die Erhebungen durch eine Prägung auf der ersten Hauptseite des Halbleiterchips aufzubringen.

Alternativ besteht die Erhebung gemäß einer nicht beanspruchten Ausführung aus dem dem zumindest einen Kontaktpad gegenüberliegenden Leiterzugende, wobei das Leiterzugende dann durch wenigstens einmaliges Galvanisieren eine zerklüftete, von der ersten Hauptseite abgewandte und gegenüber dem Leiterzug überhöhte Oberfläche aufweist. Hierbei wird das Prinzip genutzt, daß beim Galvanisieren Überhöhungen entstehen, die sich insbesondere an Kanten und Spitzen bei der Metallabscheidung ausbilden. Dieser Effekt ist an sich beim Aufbringen der Leiterzüge unerwünscht. Dieser Effekt wird jedoch gezielt ausgenutzt, indem die Enden der Leiterzüge beim Aufbringen nach Möglichkeit eine sehr rauhe Oberfläche aufweisen. Durch mehrfaches Galvanisieren entsteht somit an den Leiterzugenden eine Überhöhung, die zur direkten elektrischen Verbindung mit dem Kontaktstellensubstrat verwendet werden kann. Die Überhöhung muß dabei ausreichend hoch sein, so daß kein Kurzschluß zwischen einem Leiterzug und einem anderen metallischen Bereich auf dem Substrat entstehen kann.

Vorzugsweise wird das Leiterzugende im wesentlichen ringförmig ausgeprägt. Die Überhöhung entsteht besonders gut, wenn die innere und/oder äußere Berandung des im wesentlichen ringförmigen Leiterzugendes aufgerauht ist.

In einer weiteren Alternative ist vorgesehen, daß auf den den Kontaktpads gegenüberliegenden Leiterbahnenden mit einer zerklüfteten Oberfläche ausgeprägte Gebilde aufgebracht werden. Indem das Gebilde aus einem elektrisch leitfähigen und galvanisierbaren Material besteht, kann die zerklüftete Oberfläche durch den oben beschriebenen Effekt beim Galvanisieren gezielt weiter überhöht werden.

Die Leiterzüge werden vorteilhafterweise durch Leiterbahnen aus einem Kupfer-Nickel-Gold-Schichtstapel ausgeführt.

Die Erfindung wird anhand der nachfolgenden Figuren näher erläutert. Es zeigen:
- Figur 1: einen Halbleiterchip im Querschnitt, bei dem Erhebungen auf die erste Hauptseite aufgebracht sind,
- Figur 2: den Halbleiterchip aus Figur 1, bei dem Leiterzüge aufgebracht sind,
- Figur 3: den Halbleiterchip aus Figur 2 auf einem Substrat, mit einem noch nicht ausgehärteten Kleber zur Verbindung des Halbleiterchips und des Substrat,
- Figur 4: den auf dem Substrat aufgebrachten Halbleiterchip, bei dem der Kleber ausgehärtet ist,
- Figur 5 bis 9: verschiedene Ausgestaltungsbeispiele für die Erhebungen,
- Figur 10: Ausgestaltungsbeispiele für das Aufbringen der Leiterzüge,
- Figur 11: ein Ausführungsbeispiel eines Leiterbahnendes und
- Figur 12: ein Leiterbahnende, auf das ein Gebilde mit einer zerklüfteten Oberfläche aufgebracht ist.

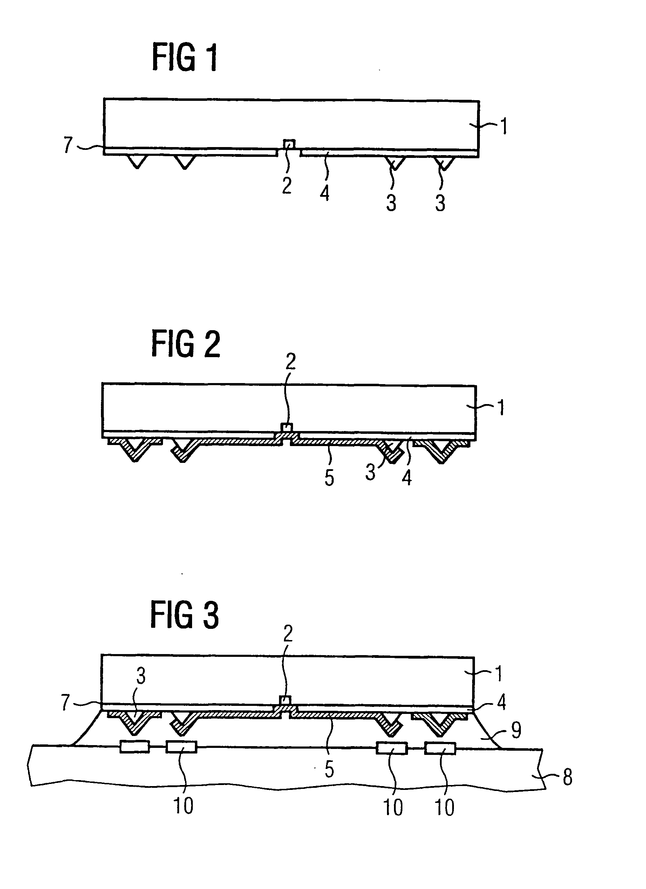

Anhand der Figuren 1 bis 4 wird nachfolgend eine erste Ausgestaltung der Erfindung verdeutlicht. Ein Halbleiterchip 1 ist mit zumindest einem Kontaktpad 2 auf einer ersten Hauptseite 7 versehen. In dem vorliegenden Ausführungsbeispiel befindet sich der zumindest eine Kontaktpad 2 in der Mitte des Halbleiterchips, wobei eine Vielzahl an Kontaktpads in einer Reihe hintereinander angeordnet sein können. Selbstverständlich ist es auch denkbar, daß die Kontaktpads 2 in mehreren parallel verlaufenden Reihen auf der ersten Hauptseite 7 angeordnet sind. Die Kontaktpads 2 könnten ebenfalls entlang der Seitenkanten des Halbleiterchips 1 verlaufen. Nach der Strukturierung des Halbleiterchips, die auf Waferebene stattfindet, weist der Halbleiterchip 1 auf der ersten Hauptseite 7 eine Schutzschicht 4 auf. Diese besteht in der Regel aus einem Polyimid oder einem Polymer. Es ist lediglich eine Öffnung vorgesehen, die die Kontaktpads 2 ausspart. Auf der Schutzschicht 4 ist eine Mehrzahl an Erhebungen 3 vorgesehen. Im vorliegenden Ausführungsbeispiel sind jeweils zwei Erhebungen 3 symmetrisch um den Kontaktpad 2 angeordnet. Die Anzahl der Erhebungen 3 wird in der Regel mit der Anzahl der Kontaktpads 2 korrespondieren. Dies ist jedoch nicht zwangsläufig notwendig.

Aus der Figur 2 ist ersichtlich, daß Leiterzüge 5 zwischen dem Kontaktpad 2 und den Erhebungen 3 verlaufen. Die Leiterzüge 5 können dabei über einen Leiterzug hinweg verlaufen, wie dies beispielsweise bei der ganz linken oder ganz rechten Erhebung dargestellt ist. Die Leiterzüge können jedoch auf dem Scheitelbereich einer Erhebung bereits enden. In der Regel wird ein Leiterzug eine Erhebung mit einem Kontaktpad 2 verbinden.

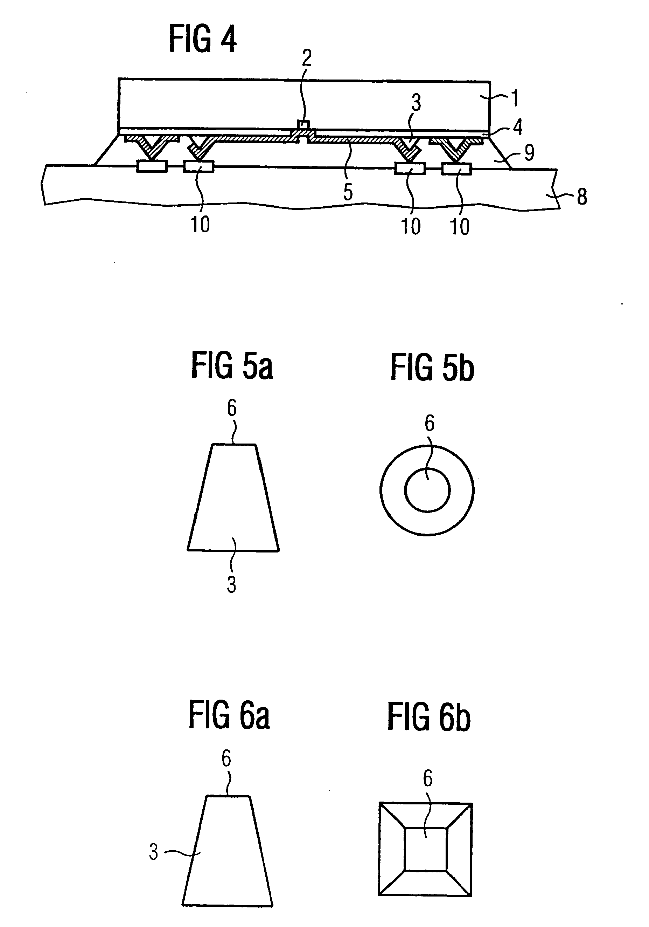

Ein derart vorbereiteter Halbleiterchip läßt sich mittels Flip-Chip-Kontaktierung mit einem Substrat elektrisch verbinden. Die Erhebungen 3 übernehmen dabei die Funktion einer Umverdrahtung. Dies bedeutet, die Abstände der Erhebungen 3 sind an die Abstände der Kontaktstellen 10 des Substrates 8 angepaßt. Hierdurch lassen sich mit Standardverfahren hergestellte Substrate 8 verwenden. Die Verbindung zwischen dem Halbleiterchip 1 und dem Substrat 8 wird durch einen Kleber 9 vorgenommen, der zur Erlangung seiner Adhesivkraft schrumpft. In Figur 3 befindet sich der Kleber 9 in einem Zustand, in dem er noch nicht vollständig ausgehärtet ist. Es besteht noch keine oder eine nur ungenügende elektrische Verbindung zwischen den als Kontakten ausgebildeten Erhebungen und den Kontaktstellen 10 des Substrates. Durch das Schrumpfen des Klebers 9 wird der Halbleiterchip an das Substrat "herangezogen". Dadurch, daß die Erhebungen 3 in der von der Hauptseite 7 abgewandten Richtung vorteilhafterweise verjüngt sind, bohren sich die Spitzen der Erhebungen 3 in die metallischen Kontaktstellen 10 des Substrates 8 hinein. Hierdurch wird ein sicherer elektrischer Kontakt ermöglicht. In der Figur 4 ist der Kleber 9 ausgehärtet, so daß die Leiterzüge auf den Erhebungen 3 in gutem elektrischen Kontakt mit den Kontaktstellen 10 des Substrates stehen.

Da das Substrat in einer Standard-Technologie hergestellt werden kann, sind die Abstände zwischen zwei Kontaktstellen 10 sowie die Größe der Kontaktstellen relativ groß ausgeführt. Der Durchmesser einer derartigen Kontaktstelle kann bis zu 300 *µ*m betragen. Der Abstand zwischen zwei Kontaktstellen beträgt zwischen 500 und 800 *µ*m. Hierdurch ist eine verhältnismäßig einfache Positionierung des Halbleiterchips auf dem Substrat möglich. Die Werkzeuge und Verfahrensschritte der Standard Surface Mount Technology (SMT) können deshalb verwendet werden.

Die Figuren 5 bis 9 zeigen verschiedene Ausgestaltungsmöglichkeiten für die Erhebung 3. Es ist hierbei jeweils ein Querschnitt und eine Draufsicht auf eine derartige Erhebung dargestellt. Aus der Figur 5 wird ersichtlich, daß die Erhebung die Form eines an der Spitze abgeschnittenen Kegels aufweist. Je spitzer das äußere Ende 6 der Erhebung 3 ausgeführt wird, desto größer ist die Kraft, mit der sich die Erhebung in die Kontaktstelle des Substrates hineinbohren kann. Daneben entsteht die für das Galvanisieren erwünschte kantige Oberfläche, so daß sich durch das Aufbringen der Leiterzüge mittels des Galvanisierverfahrens eine weitere Überhöhung ergibt.

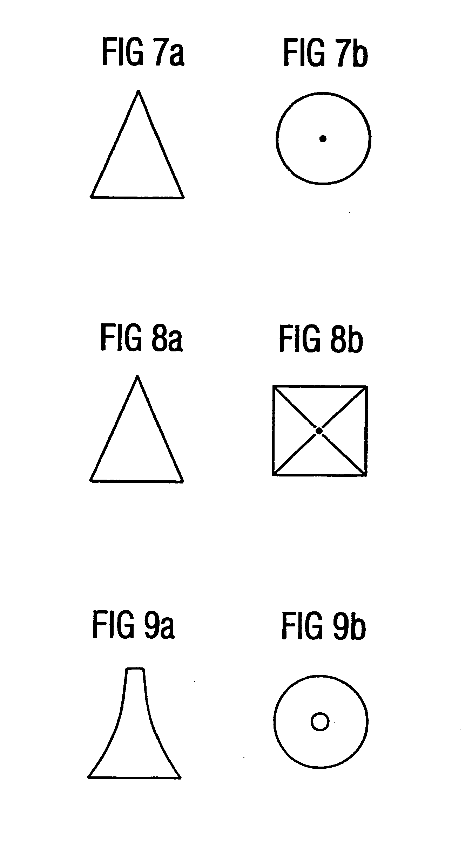

Aus Figur 6 wird ersichtlich, daß die Erhebung 3 auch die Form einer an der Spitze abgeschnittenen Pyramide aufweisen kann. In der Figur 7 ist die Erhebung als Kegel ausgeführt. Die Figur 8 zeigt die Erhebung 3 als Pyramide, bei der die Spitze nicht abgeschnitten ist. Der Randbereich der Erhebung muß nicht zwangsläufig eben oder gerade ausgeführt sein, er kann auch eine Wölbung aufweisen, wie dies beispielsweise in der Figur 9 dargestellt ist.

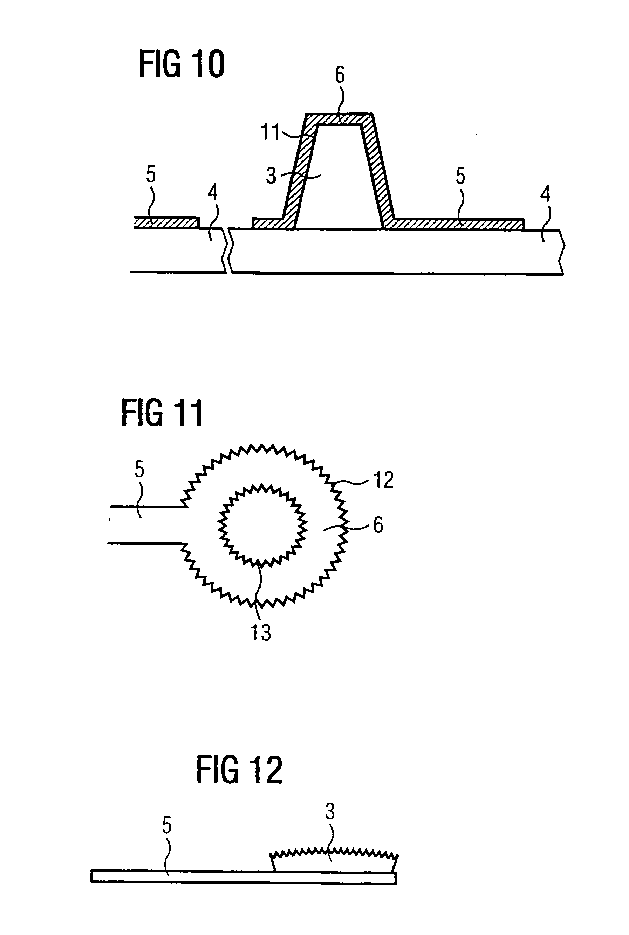

Figur 10 zeigt zwei verschiedene Möglichkeiten, die Leiterzüge 5 auf die Erhebung 3 aufzubringen. Im linken Ausführungsbeispiel verläuft der Leiterzug auf der Schutzschicht 5 entlang des Randbereiches 11 zu dem äußeren Ende 6, das er vorzugsweise vollständig bedeckt. Alternativ ist es auch denkbar, wie dies im rechten Ausführungsbeispiel gezeigt ist, den Leiterzug über die Erhebung 3 hinweg laufen zu lassen. Die Erhebung 3 kann also vollständig von dem Leiterzug 5 bedeckt sein.

Die Erhebung 3 wird vorzugsweise auf die erste Hauptseite des Halbleiterchips aufgedruckt, solange sich dieser noch im Waferbund befindet. Hierzu bieten sich insbesondere als Materialien ein Polymer oder ein Polyimid an. Es wäre selbstverständlich auch denkbar, die Erhebungen 3 in einem Prägevorgang auf die erste Hauptseite 7 aufzubringen.

Die Figur 11 zeigt ein weiteres nicht beanspruchtes Ausführungsbeispiel, bei der die Erhebung 3 auf eine andere Art und Weise erzeugt wird. Es ist das Ende eines Leiterzuges 5 dargestellt, das bevorzugt ringförmig ausgestaltet ist. Die äußere und innere Berandung 12, 13 weist in der Regel nach einem Galvanisierprozeß eine rauhe Oberfläche auf. Durch wiederholtes Galvanisieren entstehen entlang dieser rauhen Oberflächen weitere Spitzen und Überhöhungen, die durch jeden Galvanisiervorgang noch weiter ausgeprägt werden. Hierdurch lassen sich die erwünschten Erhebungen erzeugen. Normalerweise sind die durch das Galvanisieren entstehenden Überhöhungen unerwünscht und werden mittels aufwendiger Verfahrensschritte entfernt. Dieses Beispiel sieht jedoch gerade die Nutzung dieser Überhöhungen vor. Das Leiterbahnende könnte auch die Form eines vollflächigen Kreises oder Ellipsoid aufweisen, wobei dann nur entlang der äußeren Berandung Erhebungen auftreten würden.

Sind die Erhöhungen durch das mehrfache Galvanisieren nicht ausgeprägt genug, so ist es auch denkbar, auf das Leiterbahnende 5 ein beliebig gestaltetes Gebilde 3 aufzubringen, das eine zerklüftete Oberfläche aufweist. Durch das Galvanisieren kann die zerklüftete Oberfläche weiter überhöht werden.

Die Erfindung ermöglicht es in der beschriebenen Weise, den Abstand zwischen dem Halbleiterchip und dem Substrat äußerst gering zu halten. Es sind Abstände von lediglich 10 µm möglich. Die durch das Galvanisieren oder das Aufdrucken von Erhebungen erzielbaren Abstände sind ausreichend, um sicherzustellen, daß zwischen den Leiterzügen 5 auf dem Halbleiterchip und einer Metallisierung auf dem Substrat 8 keine Kurzschlüsse entstehen.

## Patentansprüche

1. Verfahren zur Herstellung einer Halbleiterbauelementanordnung mit einem Halbleiterchip (1), der auf einer ersten Hauptseite (7) zumindest zwei Kontaktpads (2) und eine die zumindest zwei Kontaktpads (2) aussparende Schutzschicht (4) aufweist und der Erhebungen (3) auf der ersten Hauptseite (7), die in der von der ersten Hauptseite (7) abgewandten Richtung verjüngt sind, aufweist, mit den Schritten:
a) Strukturierung der Halbleiterchips (1) auf der ersten Hauptseite (7) auf Waferebene,
b) Aufbringen der Erhebungen (3) auf der ersten Hauptseite (7) auf Waferebene,
c) Aufbringen von Leiterzügen (5) auf der ersten Hauptseite (7), wobei die Kontaktpads (2) und die Erhebungen (3) miteinander verbunden werden und wobei Schritt c) nach Schritt b) ausgeführt wird,
d) Vereinzeln der Halbleiterchips und
e) Verbinden eines der Halbleiterchips (1) und eines Substrates (8) mit Kontaktstellen (10) mittels eines Klebers (9), der zur Entwicklung seiner Adhäsivkraft schrumpft, wobei, wenn der Kleber (9) noch nicht ausgehärtet ist, keine oder nur ungenügende elektrische Verbindung zwischen den Erhebungen (3) und den Kontaktstellen (10) besteht und wobei beim Schrumpfen des Klebers (9) der Halbleiterchip (1) an das Substrat herangezogen wird, so dass sich die Erhebungen (3) in die Kontaktstellen (2) hineinbohren, um einen sicheren elektrischen Kontakt zu ermöglichen.

2. Verfahren nach Anspruch 1,
**dadurch gekennzeichnet, dass** die Erhebungen (3) aufgedruckt werden.

3. Verfahren nach Anspruch 1 oder 2,
**dadurch gekennzeichnet, dass** als Material für die Erhebungen (3) ein Polymer oder ein Polyimid verwendet wird.

4. Verfahren nach einem der Ansprüche 1 bis 3,
**dadurch gekennzeichnet, dass** die Leiterzüge (5) als Leiterbahnen aus einem Kupfer-Nickel-Gold-Schichtstapel ausgeführt werden.

## Claims

1. A method of manufacturing a semiconductor component arrangement comprising a semiconductor chip (1) having a first main face (7) provided with at least two contact pads (2) and a protective layer (4) exposing the at least two contact pads (2) and having protrusions (3) on the first main face (7) which taper off in the direction facing away from the first main face (7), comprising the steps:
a) patterning the semiconductor chips (1) on the first main face (7) on wafer level,
b) applying the protrusions (3) on the first main face (7) on wafer level,
c) applying conductor tracks (5) on the first main face (7), the contact pads (2) and the protrusions (3) being connected to one another and step c) being carried out after step b),
d) separating the semiconductor chips and
e) connecting one of the semiconductor chips (1) and a substrate (8) comprising contact areas (10) by means of an adhesive agent (9) which shrinks for developing its adhesive force, wherein there is no electrical connection or only an insufficient electrical connection between the protrusions (3) and the contact areas (10) when the adhesive agent (9) is not cured, and wherein the semiconductor chip (1) is pulled towards the substrate during the shrinking process of the adhesive agent (9), so that the protrusions (3) press into the contact areas (10) to facilitate a reliable electrical contact.

2. The method according to claim 1,
**characterized in that** the protrusions (3) are printed.

3. The method according to claim 1 or 2,
**characterized in that** a polymer or a polyimide is used as the material for the protrusions (3).

4. The method according to any one of the claims 1 to 3,
**characterized in that** the conductor tracks (5) are implemented as conductor paths made of a copper-nickel-gold layer stack.

## Revendications

1. Procédé de fabrication d'un agencement de composant semiconducteur avec une puce semi-conductrice (1) qui présente au moins deux patins de contact (2) d'un premier côté principal (7) et une couche de protection (4) évidant les au moins deux patins de protection (2) et qui présente, du premier côté principal (7), des élévations (3) qui sont aminçies dans le sens opposé au premier côté principal (7), comportant les étapes :
a) structuration des puces semi-conductrices (1) du premier côté principal (7) au niveau de la plaquette,
b) pose des élévations (3) du premier côté principal (7) au niveau de la plaquette,
c) pose de fils conducteurs (5) du premier côté principal (7), les patins de contact (2) et les élévations (3) étant reliés entre eux et l'étape c) étant exécutée après l'étape b),
d) séparation des puces semi-conductrices et
e) liaison d'une des puces semi-conductrices (1) et d'un substrat (8) avec des surfaces de contact (10) moyennant une colle (9) qui se rétracte pour développer sa force adhésive, sachant que, lorsque la colle (9) n'est pas encore durçie, il n'existe aucune liaison électrique ou seulement une liaison électrique insuffisante entre les élévations (3) et les surfaces de contact (10) et sachant que, lors de la rétraction de la colle (9), la puce semi-conductrice (1) est attirée contre le substrat de telle sorte que les élévations (3) s'enfoncent dans les surfaces de contact (2) afin de permettre un contact électrique sûr.

2. Procédé selon la revendication 1,
**caractérisé en ce que** les élévations (3) sont imprimées.

3. Procédé selon la revendication 1 ou 2,
**caractérisé en ce qu'**un polymère ou un polyimide est employé comme matériau pour les élévations (3).

4. Procédé selon l'une des revendications 1 à 3,
**caractérisé en ce que** les fils conducteurs (5) sont réalisés comme pistes condutrices à partir d'un empilage de couches de cuivre-nickel-or.
